(19) Europäisches Patentamt
European Patent Office
Office européen des brevets

(11) **EP 4 664 195 A2**

(12) **EUROPEAN PATENT APPLICATION**

(43) Date of publication:
**17.12.2025 Bulletin 2025/51**

(21) Application number: **25182333.2**

(22) Date of filing: **12.06.2025**

(51) International Patent Classification (IPC):
**G03F 1/24** (2012.01)     **G21K 1/06** (2006.01)

(52) Cooperative Patent Classification (CPC):
**G03F 1/24; G21K 1/062**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.06.2024   JP 2024094923**
**18.03.2025   JP 2025043637**

(71) Applicant: **SHIN-ETSU CHEMICAL CO., LTD.**
**Tokyo 1000005 (JP)**

(72) Inventors:
• **OGOSE, Taiga**
**Niigata, 942-8601 (JP)**
• **KANEKO, Hideo**
**Niigata, 942-8601 (JP)**
• **INAZUKI, Yukio**
**Niigata, 942-8601 (JP)**
• **KOSAKA, Takuro**
**Niigata, 942-8601 (JP)**

(74) Representative: **Hindles Limited**
**Clarence House**
**131-135 George Street**
**Edinburgh, EH2 4JS (GB)**

(54) **REFLECTIVE PHOTOMASK BLANK, REFLECTIVE PHOTOMASK AND METHOD FOR MANUFACTURING REFLECTIVE PHOTOMASK BLANK**

(57)     A reflective mask blank has a substrate; and a multilayer reflective film provided on the substrate and configured to reflect exposure light. The multilayer reflective film has a periodic layered structure portion including a low refractive index layer and a high refractive index layer. The low refractive index layer contains ruthenium (Ru), and further contains one or both of carbon (C) and silicon (Si).

FIG. 1

EP 4 664 195 A2

**Description**

TECHNICAL FIELD

The present invention relates to a reflective photomask blank which is a material of a reflective photomask used for manufacturing a semiconductor device such as an LSI, a reflective photomask and a method for manufacturing a reflective photomask blank.

BACKGROUND ART

In the process of manufacturing a semiconductor device, a photolithography technique of irradiating a transfer mask with exposure light and transferring a circuit pattern formed on the mask onto a semiconductor substrate (semiconductor wafer) through a reduction projection optical system is repeatedly used. Conventionally, a mainstream wavelength of the exposure light is 193 nm by argon fluoride (ArF) excimer laser light, and a pattern with dimensions smaller than the exposure wavelength has been finally formed by adopting a process called multi-patterning in which an exposure process and a processing process are combined a plurality of times.

However, since it has been necessary to form finer patterns due to continuous miniaturization of device patterns, an extreme ultraviolet (hereinafter referred to as "EUV") lithography technique using EUV light having a wavelength shorter than that of ArF excimer laser light as exposure light has been used. The EUV light is light having a wavelength of about 0.2 nm to 100 nm, more specifically, light having a wavelength of around 13.5 nm. Since the EUV light has extremely low transmittance to a substance so that a conventional transmission type projection optical system or mask cannot be used, a reflective optical element is used. Therefore, a reflective photomask is also proposed as a mask for pattern transfer.

General reflective photomask is configured such that a multilayer reflective film that reflects EUV light is provided on a substrate and an absorbing film that absorbs EUV light is formed in a pattern on the multilayer reflective film. Meanwhile, generally, a state before pattering of the absorbing film (including a state in which a resist film has been formed) is referred to as a reflective photomask blank, and this is used as a material of the reflective photomask. The reflective photomask blank has a basic structure including a substrate, a multilayer reflective film that is formed on the substrate and reflects EUV light, and in many cases, an absorbing film that is formed on the multilayer reflective film and absorbs EUV light.

As the multilayer reflective film, a multilayer reflective film that obtains a necessary reflectance with respect to EUV light by alternately laminating a molybdenum (Mo) film and a silicon (Si) film is usually used. Furthermore, a ruthenium (Ru) film is formed on the outermost layer of the multilayer reflective film as a protective film for protecting the multilayer reflective film. Meanwhile, as the absorbing film, tantalum (Ta) or the like having a relatively large value of an extinction coefficient with respect to EUV light is used (JP 2002-246299 A).

SUMMARY OF INVENTION

PROBLEM TO BE SOLVED BY INVENTION

In EUV lithography, EUV light that is exposure light is obliquely incident on a reflective mask, and an incident angle thereof is mainly set to 6 degrees with respect to a normal line of a main surface of the reflective mask. A part of the obliquely incident exposure light is blocked by the side wall of an absorber pattern, and a so-called 3D effect (three-dimensional effect, shadowing effect) occurs. The 3D effect causes positional deviation and dimensional deviation in a transfer pattern, and the smaller 3D effect is preferable in miniaturization of the pattern. Since the thinner the thickness, the smaller the 3D effect, it is desired to make the absorber pattern thinner.

On the other hand, the 3D effect varies depending on a structure of a multilayer reflective film in addition to the thickness of the absorber pattern. The reflection of the EUV light, which is the exposure light, by a multilayer reflective film is caused by superposition of reflections generated from interfaces between layers inside the multilayer reflective film. However, in the reflection of the exposure light by the multilayer reflective film, when a contribution of the reflection from a position deeper than a surface of the multilayer reflective film is large, the 3D effect becomes large. Therefore, in the multilayer reflective film, relatively increasing the contribution of the reflection from a position closer to the surface is advantageous for reducing the 3D effect and contributes to improvement of transfer performance.

In general, the multilayer reflective film has a periodic layered structure in which low refractive index layers and high refractive index layers are alternately layered. In this periodic layered structure, a Mo/Si multilayer reflective film in which molybdenum (Mo) and silicon (Si) are alternately layered, for example, by 40 cycles is formed. The Mo/Si multilayer reflective film is known to efficiently reflect the EUV light, and is currently used as a mainstream multilayer reflective film in an EUV mask blank.

As compared with molybdenum (Mo), ruthenium (Ru) is a material having a lower refractive index and a higher extinction coefficient in the EUV light, which is exposure light, having a wavelength of 13.5 nm. Therefore, a low refractive index layer of ruthenium (Ru) has a higher reflection coefficient than a low refractive index layer of molybdenum (Mo) at an ideal interface (interface without mutual diffusion or roughness) with a high refractive index layer using silicon (Si) or the like.

Therefore, in the multilayer reflective film, the multilayer reflective film (Ru/Si multilayer reflective film) using ruthenium (Ru) as the low refractive index layer can obtain a higher reflectance than the Mo/Si multilayer reflective film, with a small number of layers.

Meanwhile, in the reflective mask blank, it is necessary to detect phase defects, and it is necessary to detect finer defects. A phase defect inspection of the multilayer reflective film performed on the reflective mask blank or the reflective mask uses a method of capturing intensity and a change thereof (defect signal) of scattered light and reflected light due to a defect by inspection light having the same wavelength as the exposure light. In the inspection of the phase defect, a defect signal intensity at a location where no defect exists indicates a finite value (background level: BGL) due to the scattered light and noise. When the BGL is large, even in a location where no defect exists, the defect signal is recognized as a defect, and a so-called pseudo defect occurs. Therefore, in order to detect a finer defect, it is necessary to reduce the BGL as much as possible. When the BGL is large, the pseudo defect easily occurs, and the total number of defect detections including the pseudo defect increases. A step of discriminating between the pseudo defect and an actual defect is required for the detected defect, and an increase in the pseudo defect causes an increase in inspection time, and when there are too many pseudo defects, the defect inspection cannot be substantially performed. Therefore, it is necessary to make the BGL smaller.

In addition, warpage of the reflective mask blank due to a large film stress causes a decrease in positional accuracy when a pattern formation is performed on the reflective mask blank. In addition, when pattern transfer is performed on a wafer using a reflective mask prepared from the reflective mask blank having a large amount of warpage, there is a greater concern that positional deviation of the transfer pattern or pattern defects will occur. Therefore, the film stress is desired to be smaller.

In order to alleviate the warpage of the reflective mask blank due to the film stress, it is effective to subject the reflective mask blank to heat treatment, and the higher the temperature of the heat treatment, the better the warpage can be alleviated. However, the heat treatment at a high temperature causes mutual diffusion at the interface of each layer of the multilayer reflective film to proceed, and reduces the reflectance of the exposure light of the multilayer reflective film.

Therefore, it is preferable that the multilayer reflective film can alleviate the film stress even by heat treatment at a relatively low temperature, and it is particularly preferable that the film stress is small even without performing the heat treatment.

The present invention provides a reflective mask blank including a multilayer reflective film with small BGL at the time of the phase defect inspection and a small film stress, a reflective mask, and a method for manufacturing a reflective mask blank.

MEANS FOR SOLVING PROBLEM

As a result of intensive studies to solve the above problems, the present inventors have found that in a multilayer reflective film having a low refractive index layer containing ruthenium (Ru), when the low refractive index layer contains one or both of carbon (C) and silicon (Si) in addition to ruthenium (Ru), crystallinity of the low refractive index layer changes, the BGL at the time of the phase defect inspection decreases, and the film stress decreases, thereby completing the present invention.

A reflective mask blank according to the present invention may comprise:

a substrate; and
a multilayer reflective film provided on the substrate and configured to reflect exposure light, the multilayer reflective film including a periodic layered structure portion including a low refractive index layer and a high refractive index layer, wherein
the low refractive index layer contains ruthenium (Ru), and further contains one or both of carbon (C) and silicon (Si).

In the reflective mask blank according to the present invention,
the periodic layered structure portion may include an intermediate layer between at least one of the low refractive index layer and the high refractive index layer, the intermediate layer containing at least one selected from carbon (C), nitrogen (N), and oxygen (O).

In the reflective mask blank according to the present invention,
the periodic layered structure portion may include an intermediate layer between at least one of the low refractive index layer and the high refractive index layer, the intermediate layer containing at least one selected from molybdenum (Mo), niobium (Nb), and zirconium (Zr).

In the reflective mask blank according to the present invention,
a content of silicon (Si) of the low refractive index layer may be 4 atom% or more and 40 atom% or less, or a content of carbon (C) of the low refractive index layer may be 4 atom% or more and 40 atom% or less.

In the reflective mask blank according to the present invention,
in an X-ray diffraction pattern by CuKα rays using an out-of-plane measurement method for the multilayer reflective film, a half-value width corresponding to a diffraction angle 2θ of a diffraction peak having the highest intensity observed at a diffraction angle 2θ between 41° and 47° may be 4.0° or more.

In the reflective mask blank according to the present invention,
an absolute value of film stress of the multilayer reflective film may be 500 MPa or less.

The reflective mask blank according to the present invention may comprise a protective film containing ruthenium (Ru) provided on the multilayer reflective film.

The reflective mask blank according to the present invention may comprise an absorber film provided on the multilayer reflective film.

A reflective mask according to the present invention may comprise:

the reflective mask blank according to the present invention; and
a patterned absorber film provided on the multilayer reflective film.

In a method for manufacturing a reflective mask blank according to the present invention,
the multilayer reflective film of the reflective mask blank according to the present invention may be formed by a sputtering film formation method using a sputtering apparatus capable of mounting a plurality of targets in a chamber.

EFFECT OF INVENTION

The present invention provides a reflective mask blank, a reflective mask and a method for manufacturing a reflective mask blank, wherein a multilayer reflective film has small BGL at the time of the phase defect inspection and the multilayer reflective film has a small film stress.

BRIEF DESCRIPTION OF DRAWINGS

FIG. 1 is a longitudinal sectional view of a reflective mask blank according to an embodiment of the present invention illustrating an aspect in which an intermediate layer and a hard mask film are not provided;
FIG. 2 is a longitudinal sectional view of a reflective mask blank according to an embodiment of the present invention illustrating an aspect in which an intermediate layer is not provided;
FIG. 3 is a longitudinal sectional view of a reflective mask blank according to an embodiment of the present invention illustrating an aspect in which a first intermediate layer and a second intermediate layer are provided;
FIG. 4 is a longitudinal sectional view of a reflective mask blank according to an embodiment of the present invention illustrating an aspect in which a first intermediate layer is provided;
FIG. 5 is a longitudinal sectional view of a reflective mask blank according to an embodiment of the present invention illustrating an aspect in which a second intermediate layer is provided;
FIG. 6 is a longitudinal sectional view illustrating an aspect in which an absorber film is patterned in the reflective mask blank according to the embodiment of the present invention;
FIG. 7 is a longitudinal sectional view illustrating an aspect of the reflective mask blank according to the embodiment of the present invention;
FIG. 8 is a longitudinal sectional view illustrating an aspect in which a resist film is provided in the reflective mask blank according to the embodiment of the present invention;
FIG. 9 is a longitudinal sectional view illustrating an aspect in which a pattern of a hard mask film is formed using a patterned resist film as an etching mask in the reflective mask blank according to the embodiment of the present invention;
FIG. 10 is a longitudinal sectional view of a reflective mask blank according to an embodiment of the present invention illustrating an aspect in which a low refractive index layer is provided on a substrate and an intermediate layer is not provided;
FIG. 11 is a longitudinal sectional view of a reflective mask blank according to an embodiment of the present invention illustrating an aspect in which a low refractive index layer is provided on a substrate, a low refractive index layer is provided in a periodic layered structure portion, and an intermediate layer is not provided;
FIG. 12 is a longitudinal sectional view illustrating a reflective mask blank according to Example 1 and Comparative Example 1; and

FIG. 13 is a longitudinal sectional view illustrating a reflective mask blank according to Examples 2 to 8.

DETAILED DESCRIPTION

Hereinafter, embodiments of the present invention will be described in more detail.

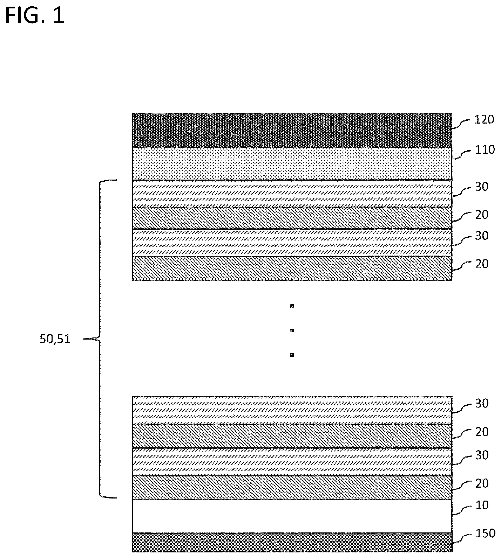

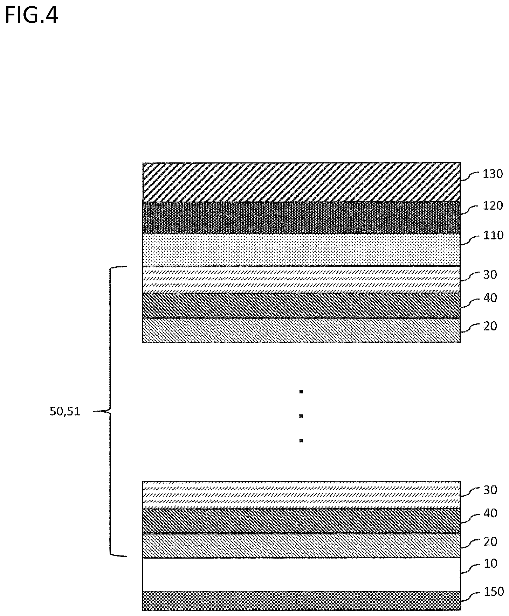

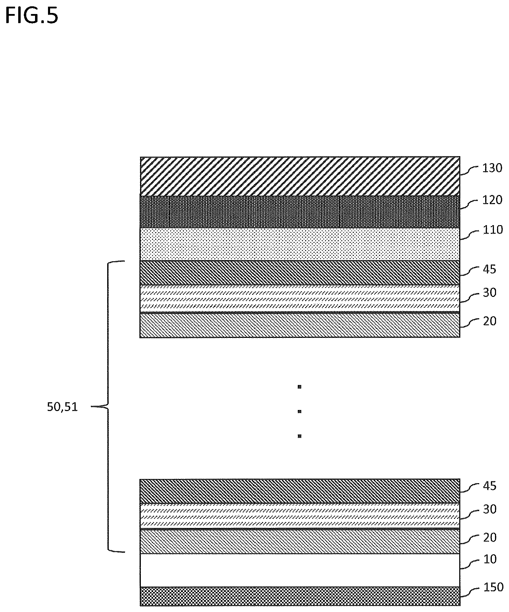

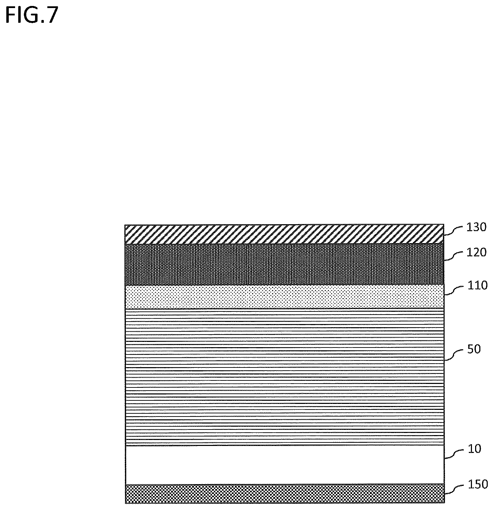

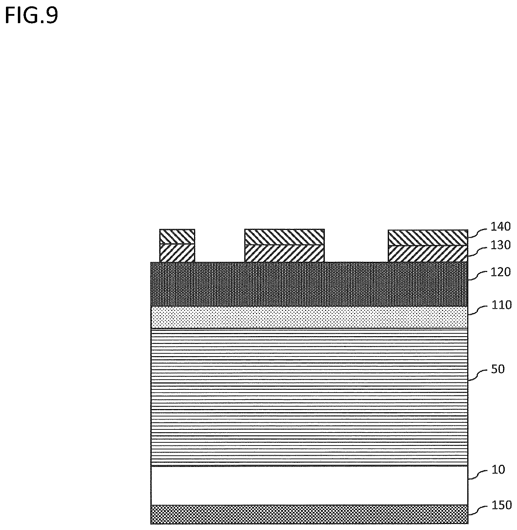

As illustrated in FIGS. 1 to 11, a reflective mask blank of the present embodiment includes a substrate 10 and a multilayer reflective film 50 formed on the substrate 10 (on one main surface (front surface) of the substrate 10) and reflecting exposure light. The reflective photomask blank according to the present embodiment is suitable as a material (EUV photomask blank) of a reflective photomask (EUV photomask) used in EUV lithography in which EUV light is used as exposure light. The EUV light used in the EUV lithography in which the EUV light is used as the exposure light has a wavelength of 13 nm to 14 nm, and is usually light having a wavelength of about 13.5 nm.

The substrate 10 preferably has low thermal expansion characteristics for use in exposure to EUV light, and for example, is preferably made of a material having a thermal expansion coefficient within a range of $\pm 2 \times 10^{-8}$/°C, preferably within a range of $\pm 5 \times 10^{-9}$/°C. Examples of such a material include titania-doped quartz glass ($SiO_2$-$TiO_2$-based glass).

In addition, it is preferable to use the substrate 10 whose surface is sufficiently planarized, and a surface roughness of the main surface of the substrate 10 is preferably 0.2 nm or less, more preferably 0.15 nm or less in RMS value. Such a surface roughness can be obtained by polishing the substrate 10 or the like. Furthermore, the substrate 10 preferably has a flatness of 100 nm or less. The substrate 10 preferably has a size in which a size of the main surface of the substrate 10 is 152 mm square and a thickness of the substrate 10 is 6.35 mm. The substrate 10 having such a size is a substrate referred to as a so-called 6025 substrate (substrate having a main surface size of 6 inch square and a thickness of 0.25 inch).

The multilayer reflective film 50 is a film in the reflective mask and reflects the EUV light that is exposure light. The multilayer reflective film 50 may be provided in contact with one main surface (for example, the front surface) of the substrate 10. The embodiment is not limited to such an aspect, and a base film may be provided between the substrate 10 and the multilayer reflective film 50. The multilayer reflective film 50 is a film in the reflective mask and reflects the EUV light that is exposure light. The multilayer reflective film 50 has a periodic layered structure in which a high refractive index layer 20 having a relatively high refractive index to the EUV light and a low refractive index layer 30 having a relatively low refractive index to the EUV light as compared with the high refractive index layer 20 are alternately layered. The high refractive index layer 20 is a layer having a relatively high refractive index at the wavelength of the exposure light, and the low refractive index layer 30 is a layer having a relatively low refractive index at the wavelength of the exposure light. The number of cycles of the periodic layered structure is preferably 10 cycles or more and particularly 20 cycles or more, and preferably 50 cycles or less, particularly 40 cycles or less, and further preferably 30 cycles or less. The value of the reflectance is preferably 50% or more, more preferably 55% or more, still more preferably 60% or more, and still more preferably 65% or more. In the present embodiment, a portion having a periodic layered structure including the low refractive index layers 30 and the high refractive index layers 20 is referred to as a periodic layered structure portion 51.

The uppermost layer of the multilayer reflective film 50 may be a protective layer having a function of protecting the multilayer reflective film 50. At this time, the high refractive index layer 20 may be provided on the uppermost layer of the multilayer reflective film 50, and the high refractive index layer 20 may have a function of protecting the multilayer reflective film 50. In a case where the high refractive index layer 20 is provided on the uppermost layer of the multilayer reflective film 50 as described above, a protective film 110, an absorber film 120, and the like described later may be provided on the high refractive index layer 20.

The high refractive index layer 20 of the present embodiment may be a layer containing silicon (Si). The high refractive index layer 20 may further contain at least one additive element selected from oxygen (O), nitrogen (N), carbon (C), boron (B), and hydrogen (H), and may include a multilayer of a layer containing the additive element and a layer not containing the additive element. The thickness of the high refractive index layer 20 is preferably 2.5 nm or more and 5.5 nm or less, and more preferably 3 nm or more and 5 nm or less.

The low refractive index layer 30 of the present embodiment may be a layer containing ruthenium (Ru). The low refractive index layer 30 preferably has a structure of microcrystalline or amorphous, and particularly preferably has a crystallite size of ruthenium (Ru) of 2.5 nm or less, more preferably 2 nm or less. Thus, the surface and interface of the multilayer reflective film 50 can be smoothed.

The size of the crystallite can be obtained by the Scherrer equation shown below.

$$\text{Crystallite diameter (nm)} = K\lambda/\beta\cos\theta$$

(where K is the Scherrer constant (Here, it is set to 0.95.), $\lambda$ is a measurement X-ray wavelength (0.154 nm), $\beta$ is a half-value width in radian of a diffraction peak, and $\theta$ is the Bragg angle (Here, the half-value width midpoint is used.) of the diffraction peak.)

The half-value width is a width of a peak at a height indicating an average intensity of an intensity that can be regarded as a background and a peak maximum intensity when the diffraction peak is drawn with a horizontal axis as a diffraction angle $2\theta$ and a vertical axis as a diffraction intensity, and is a value having a unit similar to the diffraction angle $2\theta$.

In order to obtain the preferable crystallite size as described above, in the X-ray diffraction pattern by CuK$\alpha$ ray using the out-of-plane measurement method for the multilayer reflective film 50, it is necessary that the half-value width of the diffraction peak having the highest intensity derived from Ru observed at the diffraction angle $2\theta$ between 41° and 47° be 4° or more. When no diffraction peak appears in the region, ruthenium (Ru) has an amorphous structure, and the half-value width of the diffraction peak in that case is defined as 180°.

The multilayer reflective film 50 of the present embodiment preferably has the half-value width of 4° or more. The half-value width is more preferably 5° or more.

The low refractive index layer 30 can contain one or both of carbon (C) and silicon (Si). Each of carbon (C) and silicon (Si) has an effect of changing the crystallinity of the low refractive index layer 30 containing ruthenium (Ru), can microcrystallize or amorphize the low refractive index layer 30, and can improve the smoothness of the surface and the interface of the multilayer reflective film 50. As a result, the BGL at the time of the phase defect inspection can be reduced, the effect of reducing the film stress of the multilayer reflective film 50 is also obtained, and the amount of warpage of the reflective mask blank or the reflective mask can be improved.

The BGL can be evaluated in the phase defect inspection using EUV Mask Blank Inspection and Review System (ABICS E120 manufactured by Lasertec Corporation), and the value thereof is preferably 250 or less, more preferably 230 or less, still more preferably 210 or less, and still more preferably 200 or less.

The amount of warpage of the reflective mask blank or the reflective mask is preferably 300 nm or less. For this purpose, the absolute value of the film stress of the multilayer reflective film 50 is preferably 500 MPa or less, more preferably 400 MPa or less, and still more preferably 300 MPa or less. Here, the film stress is indicated by a negative sign in the case of a compressive stress, and is indicated by a positive sign in the case of a tensile stress.

When the content of carbon (C) contained in the low refractive index layer 30 containing ruthenium (Ru) is too low, the effect of microcrystallizing or amorphizing the low refractive index layer 30 cannot be obtained, and when it is too high, the reflectance of the multilayer reflective film 50 with respect to the exposure light (EUV light) decreases. The content of carbon (C) is preferably 2 atom% or more and 40 atom% or less, more preferably 4 atom% or more and 25 atom% or less, and still more preferably 4 atom% or more and 20 atom% or less.

When the content of silicon (Si) contained in the low refractive index layer 30 containing ruthenium (Ru) is too low, the effect of microcrystallizing or amorphizing the low refractive index layer 30 cannot be obtained. On the other hand, when the content of silicon (Si) contained in the low refractive index layer 30 containing ruthenium (Ru) is too high, the reflectance of the multilayer reflective film 50 with respect to the exposure light (EUV light) decreases. Therefore, the content of silicon (Si) is preferably 4 atom% or more and 40 atom% or less, more preferably 6 atom% or more and 25 atom% or less, and still more preferably 8 atom% or more and 20 atom% or less.

When the low refractive index layer 30 contains an additive element such as boron (B), nitrogen (N), or oxygen (O) in addition to carbon (C) and silicon (Si), crystallinity can be made microcrystalline or amorphous. However, from the viewpoint of the reflectance of the multilayer reflective film 50, it is preferable to contain only one or both of carbon (C) and silicon (Si) other than ruthenium (Ru). In addition, the low refractive index layer 30 may include a multilayer of a layer containing the additive element and a layer not containing the additive element. The thickness of the low refractive index layer 30 is preferably 1.5 nm or more and 4.5 nm or less, and more preferably 2 nm or more and 4 nm or less.

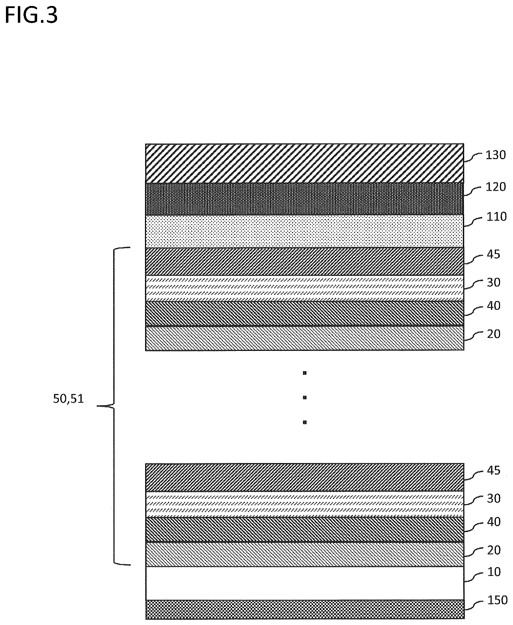

As illustrated in FIGS. 3 to 5, intermediate layers 40 and 45 may be provided between each of the low refractive index layer 30 and the high refractive index layer 20 or between some of the low refractive index layers 30 and the high refractive index layer 20 in order to prevent formation of a reaction layer generated during formation of the multilayer reflective film 50 or formation of an interdiffusion layer by heat treatment or the like after the formation of the multilayer reflective film 50. Examples of a material of the intermediate layers 40 and 45 include silicon nitride (SiN), silicon carbide (SiC), silicon oxide (SiO), molybdenum (Mo), molybdenum nitride (MoN), molybdenum carbide (MoC), molybdenum oxide (MoO), niobium (Nb), niobium nitride (NbN), niobium carbide (NbC), niobium oxide (NbO), zirconium (Zr), zirconium nitride (ZrN), zirconium carbide (ZrC), and zirconium oxide (ZrO). The thickness of the intermediate layers 40 and 45 is preferably 0.2 nm or more and 2 nm or less, and more preferably 0.3 nm or more and 1 nm or less. In the present embodiment, the intermediate layer provided on the surface of the high refractive index layer 20 on the side away from the substrate 10 is referred to as the first intermediate layer 40, and the intermediate layer provided on the surface of the low refractive index layer 30 on the side away from the substrate 10 is referred to as the second intermediate layer 45.

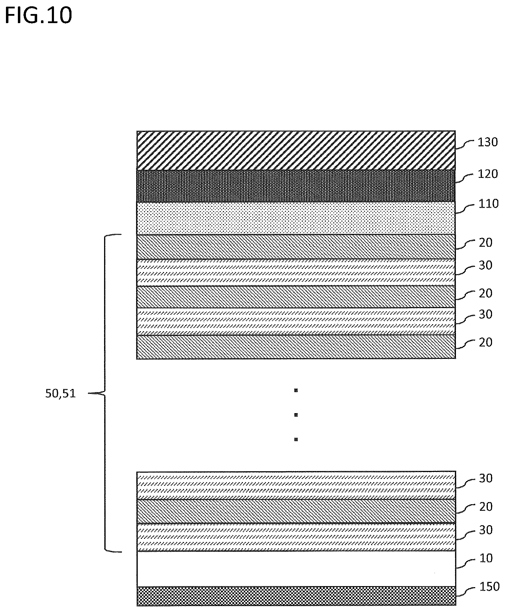

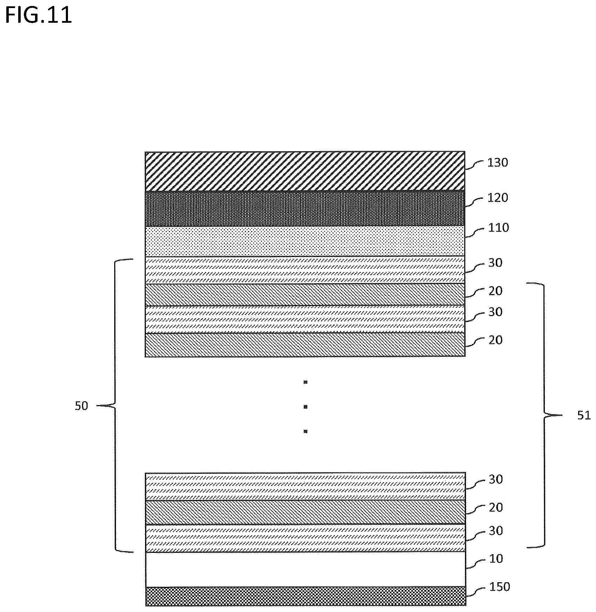

Although FIGS. 1 to 5 illustrate an aspect in which the high refractive index layer 20 is provided on the substrate 10, an aspect in which the low refractive index layer 30 is provided on the substrate 10 as illustrated in FIGS. 10 and 11 can also be adopted. FIG. 11 illustrates an aspect in which the low refractive index layer 30 is provided on an upper surface of the periodic layered structure portion 51. On the other hand, in FIGS. 1 to 5 and 10, the periodic layered structure portion 51 constitutes the multilayer reflective film 50.

Examples of a method for forming the multilayer reflective film 50 include a sputtering method in which power is supplied to a target, an atmospheric gas is converted into plasma (ionized) with the supplied power, and sputtering is performed, and an ion beam sputtering method in which a target is irradiated with an ion beam. Examples of the sputtering method include a DC sputtering method in which a DC voltage is applied to a target, and an RF sputtering method in which a radio frequency voltage is applied to a target. In particular, magnetron sputtering, which utilizes a magnetic field to promote ionization of gas and perform efficient sputtering, is advantageous in terms of productivity. The power applied to a target may be DC or RF, and the case of DC also includes pulse sputtering that inverts a negative bias applied to a target for a short time to prevent charge-up of the target.

The multilayer reflective film 50 can be formed, for example, by a sputtering method using a sputtering apparatus on which a plurality of targets can be mounted. Specifically, A target is appropriately selected from a ruthenium (Ru) target for forming a layer containing ruthenium (Ru), a silicon (Si) target for forming a layer containing silicon (Si), a carbon (C) target for forming a layer containing carbon (C), a molybdenum (Mo) target for forming a layer containing molybdenum (Mo) and the like. A rare gas such as a neon (Ne) gas, an argon (Ar) gas, a krypton (Kr) gas, or a xenon (Xe) gas is used as the sputtering gas.

When the layer containing nitrogen (N) is formed, the layer can be formed by reactive sputtering using a nitrogen-containing gas such as a nitrogen ($N_2$) gas simultaneously with a rare gas. When the layer containing oxygen (O) is formed, the layer can be formed by reactive sputtering using an oxygen-containing gas such as an oxygen ($O_2$) gas simultaneously with the rare gas.

When the layer containing carbon (C) is formed, the layer can be formed by using a carbon (C) target simultaneously with another target (a ruthenium (Ru) target, a silicon (Si) target, a molybdenum (Mo) target, a niobium (Nb) target, a zirconium (Zr) target, or the like), and can also be formed by reactive sputtering using a carbon oxide gas such as a carbon monoxide (CO) gas and a carbon dioxide ($CO_2$) gas, a hydrocarbon gas such as a methane ($CH_4$) gas, or the like simultaneously with the rare gas.

Furthermore, when a layer containing boron (B) is formed, a boron carbide ($B_4C$) target, a ruthenium target to which boron (B) is added (ruthenium boride (RuB) target), the silicon (Si) target to which boron (B) is added (silicon boride (SiB) target), or the like can be used.

As illustrated in FIGS. 1 to 11, the protective film 110 for protecting the multilayer reflective film 50 may be provided on the multilayer reflective film 50. As the material of the protective film 110, a material containing ruthenium (Ru) is suitably used. The protective film 110 is required to have a function of protecting the multilayer reflective film 50 from various dry etching and cleaning in the reflective mask manufacturing process, an exposure environment at the time of using the reflective mask, a cleaning process in the reproduction process after use, and the like, and a film containing an additive element such as niobium (Nb), zirconium (Zr), titanium (Ti), or rhodium (Rh) and having resistance to various processes is suitably used, and may have a multilayer structure made of these materials.

The protective film 110 may be formed with another film interposed between the protective film 110 and the multilayer reflective film 50, but is usually formed in contact with the multilayer reflective film 50.

The protective film 110 can be formed by, for example, a sputtering method. As the target, in order to form a film or layer containing ruthenium (Ru), the ruthenium (Ru) target or a ruthenium (Ru) alloy target can be used, and in order to form a film or layer containing niobium (Nb), the niobium (Nb) target or a niobium (Nb) alloy target can be used. Specifically, the target can be appropriately selected and used from the ruthenium (Ru) target, the niobium (Nb) target, an alloy target of ruthenium (Ru) and niobium (Nb), and the like. The protective film 110 (each layer constituting the protective film 110) can be formed by sputtering using a rare gas such as a neon (Ne) gas, an argon (Ar) gas, a krypton (Kr) gas, or a xenon (Xe) gas as a sputtering gas, or by reactive sputtering using a reactive gas such as an oxygen-containing gas, a nitrogen-containing gas, or a carbon-containing gas together with the rare gas. The film thickness of the protective film 110 is not particularly limited, but is usually from about 2 nm to about 5 nm.

As illustrated in FIGS.. 1 to 11, the reflective mask blank of the present embodiment may further include the absorber film 120 that absorbs the exposure light and functions as a pattern formation film on the protective film 110. The reflective mask (EUV mask) may be manufactured as a reflective mask blank (EUV mask blank) including the substrate 10, the multilayer reflective film 50, the protective film 110, and the absorber film 120 by patterning the absorber film 120.

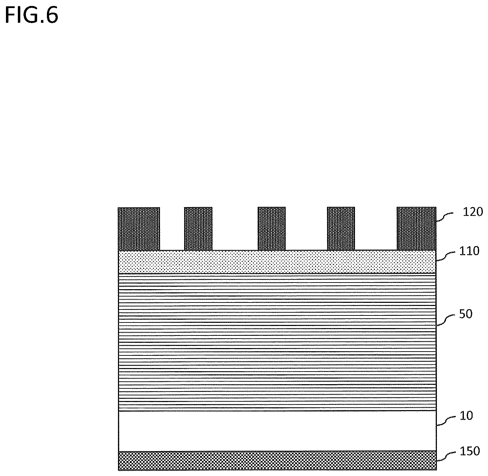

Specific examples of such a reflective mask blank include one including the substrate 10, the multilayer reflective film 50 formed on one main surface of the substrate 10 and reflecting the exposure light, the protective film 110 formed on the multilayer reflective film 50, and the absorber film 120 formed on the protective film 110 and absorbing the exposure light. From the reflective mask blank including the multilayer reflective film 50, the protective film 110, and the absorber film 120, the reflective mask including the substrate 10, the multilayer reflective film 50 formed on one main surface of the substrate 10 and reflecting the exposure light, the protective film 110 formed on the multilayer reflective film 50, and a pattern (absorber pattern) of the absorber film 120 formed on the protective film 110 and absorbing the exposure light can be manufactured (see FIG. 6). The absorber film 120 is a film that absorbs the exposure light, specifically, the EUV light, and reduces the reflectance. In addition, the absorber film 120 may be a phase shift film having a phase shift function of absorbing part of the exposure light and reflecting the part of the exposure light as reflected light having a phase changed by about from 150° to about 250°.

The material of the absorber film 120 is not limited as long as it is a material that absorbs the EUV light and can be patterned. Examples of the material of the absorber film 120 include a material containing tantalum (Ta) or chromium (Cr). The material containing Ta or Cr may contain oxygen (O), nitrogen (N), carbon (C), boron (B), or the like. Examples of the material containing Ta include Ta alone and tantalum compounds such as TaO, TaN, TaON, TaC, TaCN, TaCO, TaCON, TaB, TaOB, TaNB, TaONB, TaCB, TaCNB, TaCOB, and TaCONB. Specific examples of the material containing Cr include Cr alone and chromium compounds such as CrO, CrN, CrON, CrC, CrCN, CrCO, CrCON, CrB, CrOB, CrNB, CrONB, CrCB, CrCNB, CrCOB, and CrCONB.

Furthermore, in a case where the absorber film 120 is the phase shift film having the phase shift function, examples of the material include a material containing ruthenium (Ru). The material containing ruthenium (Ru) may be an alloy with another metal element, may contain a light element such as oxygen (O) or nitrogen (N), or may be a multilayer with another material layer.

The absorber film 120 can be formed by sputtering, and the sputtering is preferably magnetron sputtering. Specifically, the absorber film 120 can be formed by sputtering using a metal target such as a chromium (Cr) target, the tantalum (Ta) target, or the ruthenium (Ru) target, or a metal compound target (target containing a metal such as Cr, Ta, or Ru, another metal element, a light element such as oxygen (O), nitrogen (N), carbon (C), or boron (B), or the like) such as a chromium compound target, a tantalum compound target, or a ruthenium compound target and using a rare gas such as a neon (Ne) gas, an argon (Ar) gas, a krypton (Kr) gas, or a xenon (Xe) gas as a sputtering gas, or reactive sputtering using a reactive gas such as an oxygen-containing gas, a nitrogen-containing gas, or a carbon-containing gas together with the rare gas. The film thickness of the absorber film 120 is not particularly limited, but is usually from about 20 nm to about 80 nm.

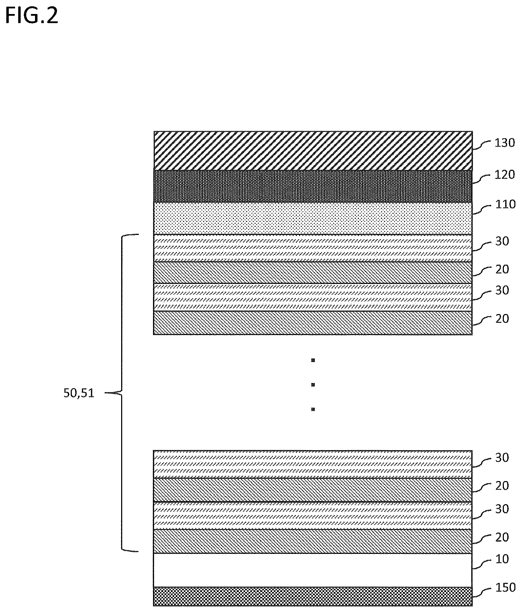

As illustrated in FIGS. 2 to 5 and FIGS. 7 to 11, a hard mask film (an etching mask film of the absorber film 120) 130 having an etching characteristic different from that of the absorber film 120 may be provided preferably in contact with the absorber film 120 on the absorber film 120 on the side away from the substrate 10. The hard mask film 130 is a film that functions as an etching mask when the absorber film 120 is subjected to dry etching. After the absorber pattern is formed, the hard mask film 130 may be, for example, left as a reflectance reduction layer for reducing the reflectance at the wavelength of light used in inspection such as pattern inspection to form a part of the absorber film 120 or removed so as not to remain on the reflective mask. Examples of the material of the hard mask film 130 include a material containing chromium (Cr). The hard mask film 130 made of a material containing Cr is particularly suitable in a case where the absorber film 120 is made of a material containing Ta and not containing Cr. When a layer (reflectance reduction layer) mainly having a function of reducing the reflectance at the wavelength of light used in inspection such as pattern inspection is formed on the absorber film 120, the hard mask film 130 can be formed on the reflectance reduction layer of the absorber film 120. The hard mask film 130 can be formed by, for example, a magnetron sputtering method. The thickness of the hard mask film 130 is not particularly limited, but is usually from about 5 nm to about 20 nm.

As shown in Figures 1 to 11, in the reflective mask blank, on the other main surface (back surface) which is a surface opposite to the one main surface of the substrate 10, a conductive film 150 used to electrostatically chuck the reflective photomask to an exposure apparatus may be provided, preferably in contact with the other main surface.

The conductive film 150 preferably has a sheet resistance of 100 $\Omega$/A or less, and a material thereof is not particularly limited. Examples of the material of the conductive film 150 include a material containing tantalum (Ta) or chromium (Cr). In addition, the material containing tantalum (Ta) or the material containing chromium (Cr) may contain oxygen (O), nitrogen (N), carbon (C), boron (B) or the like. Examples of the material containing tantalum (Ta) include tantalum (Ta) compounds such as a simple substance of Ta, TaO, TaN, TaON, TaC, TaCO, TaCN, TaCON, TaB, TaOB, TaNB, TaONB, TaCB, TaCOB, TaCNB, and TaCONB. Specific examples of the material containing chromium (Cr) include chromium (Cr) compounds such as a simple substance of Cr, CrO, CrN, CrON, CrC, CrCO, CrCN, CrCON, CrB, CrOB, CrNB, CrONB, CrCB, CrCOB, CrCNB, CrCONB.

The thickness of the conductive film 150 is not particularly limited as long as it functions for an electrostatic chuck, and is usually from about 20 nm to about 300 nm. The thickness of the conductive film 150 is preferably set so that the film stress is balanced with the multilayer reflective film 50 and the pattern (absorber pattern) of the absorber film 120 after being formed as the reflective mask, particularly after the pattern (absorber pattern) of the absorber film 120 is formed. The conductive film 150 may be formed before the multilayer reflective film 50 is formed, or may be formed after all the films on the multilayer reflective film 50 side of the substrate 10 are formed. Alternatively, the conductive film 150 may be formed after a part of the films on the multilayer reflective film 50 side of the substrate 10 is formed, and then the remaining films on the multilayer reflective film 50 side of the substrate 10 may be formed. The conductive film 150 can be formed by, for example, a magnetron sputtering method.

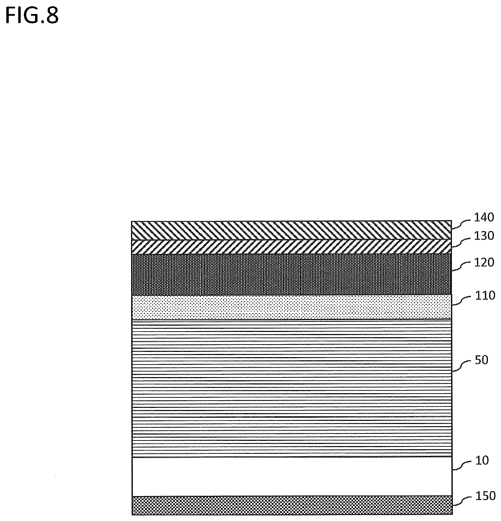

As illustrated in FIG. 8, the reflective photomask blank may further have a resist film 140 formed on the side farthest from the substrate 10. In the present embodiment, the resist film 140 is preferably an electron beam (EB) resist. Moreover, it is preferable that the resist film 140 is removable by SPM cleaning.

[Examples]

Hereinafter, the present invention will be specifically described with reference to Examples and Comparative Examples, but the present invention is not limited to the following Examples.

[Example 1]

As the substrate 10, a low thermal expansion glass substrate ($SiO_2$-$TiO_2$-based glass substrate) having a size of 152 mm square and a thickness of 6.35 mm was used. As the sputtering apparatus, an apparatus that can mount a plurality of targets and simultaneously discharge one target or the plurality of targets was used. The multilayer reflective film 50 was formed by DC magnetron sputtering while causing the target and the main surface of the substrate 10 to face each other and rotating the substrate 10. The substrate 10 had a Young's modulus of 67.6 GPa and a Poisson's ratio of 0.17, and the flatness within a 142 mm square of the central portion of the main surface of the substrate 10 was 100 nm or less.

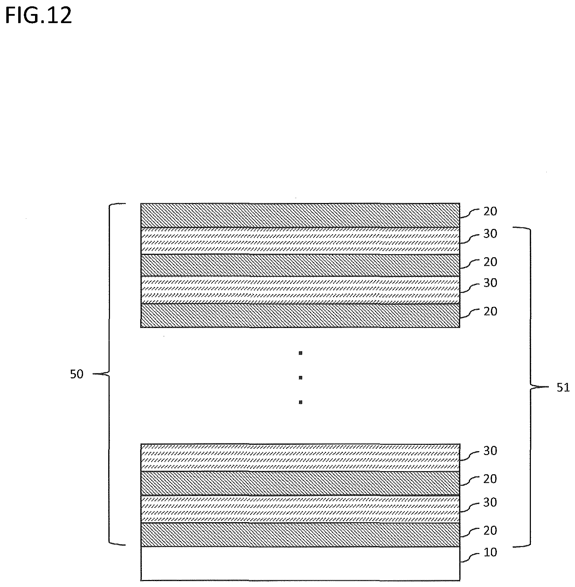

More specifically, a silicon (Si) target, the ruthenium (Ru) target, and a carbon (C) target were mounted in a chamber of the sputtering apparatus, and the substrate 10 was placed. First, power was applied to the silicon (Si) target while flowing an argon (Ar) gas (flow rate: 12 SCCM) in the chamber, a silicon (Si) layer having a thickness of 4 nm was formed as the high refractive index layer 20, and the application of the power to the silicon (Si) target was stopped. Next, power was applied to the ruthenium (Ru) target and the carbon (C) target while flowing the argon (Ar) gas (flow rate: 15 SCCM) in the chamber, a ruthenium (Ru) layer containing carbon (C) (RuC layer) having a thickness of 3 nm was formed as the low refractive index layer 30, and the application of the power to the ruthenium (Ru) target and the carbon (C) target was stopped. The content of carbon (C) contained in the low refractive index layer 30 was set to 15 atom%. The operation of forming the high refractive index layer 20 and the low refractive index layer 30 was set to 1 cycle, and this was repeated 30 cycles to form a periodic layered structure (periodic layered structure portion 51). After the formation of the low refractive index layer 30 of the 30th cycle, finally, the silicon (Si) layer of 4 nm was formed as the uppermost layer of the multilayer reflective film 50 by the above-described method to form the multilayer reflective film 50 (see FIG. 12).

With respect to the obtained multilayer reflective film 50, the X-ray diffraction pattern was measured by $CuK\alpha$ rays using an out-of-plane measurement method. As a result, a diffraction peak was observed at a diffraction angle ($2\theta$) of 43.1°, and the half-value width thereof was 6.0°.

The crystallite size calculated from the following Scherrer equation was 1.5 nm.

$$\mathtt{Crystallite\ diameter\ (nm)\ =\ K\lambda/\beta cos\theta}$$

(where K is the Scherrer constant (Here, it was set to 0.95.), $\lambda$ is a measurement X-ray wavelength (0.154 nm), $\beta$ is a half-value width in radian of a diffraction peak, and $\theta$ is the Bragg angle (Here, the half-value width midpoint was used.) of the diffraction peak.)

With respect to the obtained reflective mask blank including the substrate 10 and the multilayer reflective film 50, a change ($\Delta$TIR) in the amount of warpage within a 142 mm square of the central portion of the substrate 10 before and after the multilayer reflective film 50 was formed was measured. The change in the amount of warpage due to the compressive stress was defined as negative, and the change in the amount of warpage due to the tensile stress was defined as positive. The change ($\Delta$TIR) in the amount of warpage of the reflective mask blank according to Example 1 was -0.83 $\mu$m, and the film stress was -420 MPa when the compressive stress was defined as negative and the tensile stress was defined as positive.

With respect to the obtained reflective mask blank including the substrate 10 and the multilayer reflective film 50, the phase defect inspection using EUV Mask Blank Inspection and Review System (ABICS E120 manufactured by Lasertec Corporation) was performed, and the background level (BGL) was confirmed. As a result, the BGL was 194.

[Examples 2 to 5]

As the substrate 10, a low thermal expansion glass substrate ($SiO_2$-$TiO_2$-based glass substrate) having a size of 152 mm square and a thickness of 6.35 mm was used. As the sputtering apparatus, an apparatus that can mount a plurality of targets and simultaneously discharge one target or the plurality of targets was used. The multilayer reflective film 50 was formed by DC magnetron sputtering while causing the target and the main surface of the substrate 10 to face each other and rotating the substrate 10. The substrate 10 had a Young's modulus of 67.6 GPa and a Poisson's ratio of 0.17, and the flatness within a 142 mm square of the central portion of the main surface of the substrate 10 was 100 nm or less.

More specifically, a silicon (Si) target, the ruthenium (Ru) target, and a carbon (C) target were mounted in a chamber of the sputtering apparatus, and the substrate 10 was placed. First, power was applied to the silicon (Si) target while flowing an argon (Ar) gas (flow rate: 12 SCCM) in the chamber, a silicon (Si) layer having a thickness of 3.5 nm was formed as the high refractive index layer 20, and the application of the power to the silicon (Si) target was stopped.

Next, power was applied to the silicon (Si) target while flowing the argon (Ar) gas (flow rate: 15 SCCM) and a nitrogen ($N_2$) gas (flow rate: 50 SCCM) in the chamber, a silicon nitride (SiN) layer having a thickness of 0.5 nm was formed as the first intermediate layer 40 on the side of the high refractive index layer 20 away from the substrate 10, and the application of the power to the silicon (Si) target was stopped.

Next, power was applied to the ruthenium (Ru) target and the carbon (C) target while flowing the argon (Ar) gas (flow rate: 15 SCCM) in the chamber, a ruthenium (Ru) layer containing carbon (C) (RuC layer) having a thickness of 2.5 nm was formed as the low refractive index layer 30, and the application of the power to the ruthenium (Ru) target and the carbon (C) target was stopped. The content of carbon (C) contained in the low refractive index layer 30 was set to 4 atom%, 15 atom%, 25 atom%, and 40 atom% in Examples 2, 3, 4, and 5, respectively.

Next, power was applied to the silicon (Si) target while flowing the argon (Ar) gas (flow rate: 15 SCCM) and the nitrogen ($N_2$) gas (flow rate: 50 SCCM) in the chamber, a silicon nitride (SiN) layer having a thickness of 0.5 nm was formed as the second intermediate layer 45 on the side of the low refractive index layer 30 away from the substrate 10, and the application of the power to the silicon (Si) target was stopped.

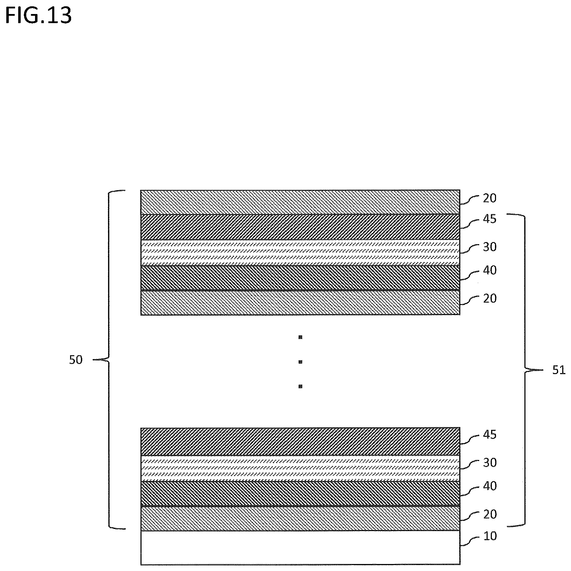

The operation of forming the high refractive index layer 20, the first intermediate layer 40 on the side of the high refractive index layer 20 away from the substrate 10, the low refractive index layer 30, the second intermediate layer 45 on the side of the low refractive index layer 30 away from the substrate 10 was set to 1 cycle, and this was repeated 30 cycles to form a periodic layered structure (periodic layered structure portion 51). After the formation of the second intermediate layer 45 of the 30th cycle on the side of the low refractive index layer 30 away from the substrate 10, finally, the silicon (Si) layer of 4 nm was formed as the uppermost layer of the multilayer reflective film 50 by the above-described method to form the multilayer reflective film 50 (see FIG. 13).

With respect to the obtained multilayer reflective film 50, the X-ray diffraction pattern was measured in the same manner as in Example 1. As a result, diffraction peaks were observed at diffraction angles ($2\theta$) of 42.4°, 43.3°, 44.1°, and 45.3°, and the half-value widths thereof were 4.0°, 5.5°, 6.9°, and 9.0° in Examples 2, 3, 4, and 5, respectively. In addition, the crystallite sizes calculated from the Scherrer equation were 2.2 nm, 1.6 nm, 1.3 nm, and 1.0 nm in Examples 2, 3, 4, and 5, respectively.

With respect to the obtained reflective mask blank, the change in the amount of warpage ($\Delta$TIR) was measured in the same manner as in Example 1. As a result, the change was -0.92 $\mu$m, -0.55 $\mu$m, -0.47 $\mu$m, and -0.54 $\mu$m, and the film stress was -470 MPa, -280 MPa, -240 MPa, and -270 MPa in Examples 2, 3, 4, and 5, respectively.

With respect to the obtained reflective mask blank, the background level (BGL) was confirmed in the same manner as in Example 1. As a result, the BGL was 222, 202, 197 and 192 in Examples 2, 3, 4 and 5, respectively.

With respect to the obtained multilayer reflective film 50, the reflectance of the EUV light having a wavelength from 13 nm to 14.1 nm at an incident angle of 6 degrees was measured. As a result, the center wavelengths (half-value width midpoint) were all 13.5 nm, and the reflectance at the wavelength of 13.5 nm was 62.4%, 61.7%, 61.1%, and 59.7% in Examples 2, 3, 4, and 5, respectively.

From the comparison between Example 1 and Example 3, it has been found that the film stress is further reduced when the intermediate layers 40 and 45 made of SiN are provided. From the results of Example 2 to 5, it has been found that the crystallite size, the film stress, BGL, and the reflectance of the EUV light change depending on the amount of carbon contained in the low refractive index layer 30.

[Example 6]

A reflective mask blank including the substrate 10 and the multilayer reflective film 50 was obtained in the same manner as in Example 2 except that power was applied to the ruthenium (Ru) target and the carbon (C) target while flowing the xenon (Xe) gas (flow rate: 8.7 SCCM) in the chamber to form the ruthenium (Ru) layer (RuC layer) containing carbon (C) having a thickness of 2.5 nm as the low refractive index layer 30, and that the content of carbon (C) contained in the low refractive index layer 30 was 5 atom% (see FIG. 13).

With respect to the obtained multilayer reflective film 50, the X-ray diffraction pattern was measured by the same method as in Example 1, As a result, a diffraction peak was observed at a diffraction angle ($2\theta$) of 43.3°, and the half-value width thereof was 5.2°. The crystallite size calculated from the Scherrer equation was 1.7 nm.

With respect to the obtained reflective mask blank, the change in the amount of warpage ($\Delta$TIR) was measured in the same manner as in Example 1, As a result, the change was -0.39 $\mu$m, and the film stress was -200 MPa.

With respect to the obtained reflective mask blank, the background level (BGL) was confirmed in the same manner as in Example 1. As a result, the BGL was 212.

With respect to the obtained multilayer reflective film 50, the reflectance of the EUV light was measured in the same manner as in Examples 2 to 5. As a result, the center wavelength (half-value width midpoint) was 13.5 nm, and the reflectance at the wavelength of 13.5 nm was 61.9%. It was found that when the xenon (Xe) gas was used as the sputtering gas for forming the RuC layer, the film stress was effectively reduced.

[Example 7]

As the substrate 10, a low thermal expansion glass substrate (SiO$_2$-TiO$_2$-based glass substrate) having a size of 152 mm square and a thickness of 6.35 mm was used. As the sputtering apparatus, an apparatus that can mount a plurality of targets and simultaneously discharge one target or the plurality of targets was used. The multilayer reflective film 50 was formed by DC magnetron sputtering while causing the target and the main surface of the substrate 10 to face each other and rotating the substrate 10. The substrate 10 had a Young's modulus of 67.6 GPa and a Poisson's ratio of 0.17, and the flatness within a 142 mm square of the central portion of the main surface of the substrate 10 was 100 nm or less.

More specifically, the silicon (Si) target, the ruthenium (Ru) target, the carbon (C) target, and the molybdenum (Mo) target were mounted in the chamber of the sputtering apparatus, and the substrate 10 was placed. First, power was applied to the silicon (Si) target while flowing an argon (Ar) gas (flow rate: 12.5 SCCM) in the chamber, a silicon (Si) layer having a thickness of 3.5 nm was formed as the high refractive index layer 20, and the application of the power to the silicon (Si) target was stopped.

Next, power was applied to the silicon (Si) target while flowing the argon (Ar) gas (flow rate: 15 SCCM) and a nitrogen (N$_2$) gas (flow rate: 50 SCCM) in the chamber, a silicon nitride (SiN) layer having a thickness of 0.5 nm was formed as the first intermediate layer 40 on the side of the high refractive index layer 20 away from the substrate 10, and the application of the power to the silicon (Si) target was stopped.

Next, power was applied to the ruthenium (Ru) target and the carbon (C) target while flowing the argon (Ar) gas (flow rate: 15 SCCM) in the chamber, a ruthenium (Ru) layer containing carbon (C) (RuC layer) having a thickness of 2.5 nm was formed as the low refractive index layer 30, and the application of the power to the ruthenium (Ru) target and the carbon (C) target was stopped. The content of carbon (C) contained in the low refractive index layer 30 was set to 15 atom%.

Next, power was applied to the molybdenum (Mo) target while flowing the argon (Ar) gas (flow rate: 15 SCCM) in the chamber, a molybdenum (Mo) layer having a thickness of 0.5 nm was formed as the second intermediate layer 45 on the side of the low refractive index layer 30 away from the substrate 10, and the application of the power to the molybdenum (Mo) target was stopped.

The operation of forming the high refractive index layer 20, the first intermediate layer 40 on the side of the high refractive index layer 20 away from the substrate 10, the low refractive index layer 30, the second intermediate layer 45 on the side of the low refractive index layer 30 away from the substrate 10 was set to 1 cycle, and this was repeated 30 cycles to form a periodic layered structure (periodic layered structure portion 51). After the formation of the second intermediate layer 45 of the 30th cycle on the side of the low refractive index layer 30 away from the substrate 10, finally, the silicon (Si) layer of 4 nm was formed as the uppermost layer of the multilayer reflective film 50 by the above-described method to form the multilayer reflective film 50 (see FIG. 13).

With respect to the obtained multilayer reflective film 50, the X-ray diffraction pattern was measured by the same method as in Example 1, As a result, a diffraction peak was observed at a diffraction angle (2θ) of 43.3°, and the half-value width thereof was 5.3°. The crystallite size calculated from the Scherrer equation was 1.7 nm.

With respect to the obtained reflective mask blank, the change in the amount of warpage (ΔTIR) was measured in the same manner as in Example 1, As a result, the change was -0.94 μm, and the film stress was -480 MPa.

With respect to the obtained reflective mask blank, the background level (BGL) was confirmed in the same manner as in Example 1. As a result, the BGL was 228.

With respect to the obtained multilayer reflective film 50, the reflectance of the EUV light was measured in the same manner as in Examples 2 to 5. As a result, the center wavelength (half-value width midpoint) was 13.5 nm, and the reflectance at the wavelength of 13.5 nm was 65.1%.

From comparison with Example 3, it has been found that when the molybdenum (Mo) layer is used as the second intermediate layer 45 on the side of the low refractive index layer 30 away from the substrate 10, the reflectance of the EUV light is effectively increased although the film stress is increased.

[Example 8]

A reflective mask blank including the substrate 10 and the multilayer reflective film 50 was obtained in the same manner as in Example 7 except that power was applied to the ruthenium (Ru) target and the silicon (Si) target while flowing the argon (Ar) gas (flow rate: 15 SCCM) in the chamber to form the ruthenium (Ru) layer containing silicon (Si) (RuSi layer) having a thickness of 2.5 nm as the low refractive index layer 30, and the content of silicon (Si) was 15 atom% (see FIG. 13).

With respect to the obtained multilayer reflective film 50, the X-ray diffraction pattern was measured by the same method as in Example 1, As a result, a diffraction peak was observed at a diffraction angle (2θ) of 41.4°, and the half-value width thereof was 4.0°. The crystallite size calculated from the Scherrer equation was 2.2 nm.

With respect to the obtained reflective mask blank, the change in the amount of warpage (ΔTIR) was measured in the same manner as in Example 1, As a result, the change was -0.83 μm, and the film stress was -420 MPa.

With respect to the obtained reflective mask blank, the background level (BGL) was confirmed in the same manner as in Example 1. As a result, the BGL was 214.

With respect to the obtained multilayer reflective film 50, the reflectance of the EUV light was measured in the same manner as in Examples 2 to 5. As a result, the center wavelength (half-value width midpoint) was 13.5 nm, and the reflectance at the wavelength of 13.5 nm was 63.6%.

[Comparative Example 1]

A reflective mask blank including the substrate 10 and the multilayer reflective film 50 was obtained in the same manner as in Example 1 except that the ruthenium (Ru) layer not containing carbon (C) and having a thickness of 3 nm was formed as the low refractive index layer 30 (see FIG. 12).

With respect to the obtained multilayer reflective film 50, the X-ray diffraction pattern was measured by the same method as in Example 1, As a result, a diffraction peak was observed at a diffraction angle (2θ) of 42.0°, and the half-value width thereof was 3.4°. The crystallite size calculated from the Scherrer equation was 2.7 nm.

With respect to the obtained reflective mask blank, the change in the amount of warpage (ΔTIR) was measured in the same manner as in Example 1, As a result, the change was -1.87 μm, and the film stress was -950 MPa.

With respect to the obtained reflective mask blank, the background level (BGL) was confirmed in the same manner as in Example 1. As a result, the BGL was 265.

According to the present embodiment, in the multilayer reflective film 50 including the low refractive index layer 30 containing ruthenium (Ru), since the low refractive index layer 30 contains one or both of carbon (C) and silicon (Si), crystallinity is reduced, and the film stress can be reduced and the BGL at the time of the phase defect inspection can be reduced. By reducing the film stress of the multilayer reflective film 50, the heat treatment temperature for alleviating the warpage can be lowered or made unnecessary, and the EUV reflectance can be improved. In addition, by reducing the BGL, the phase defect inspection with high sensitivity can be performed and the quality of the reflective mask blank and the reflective mask can be improved.

REFERENCE SIGNS LIST

| | |
|---|---|
| 10 | Substrate |
| 20 | High refractive index layer |
| 30 | Low refractive index layer |
| 40 | First intermediate layer (intermediate layer) |
| 45 | Second intermediate layer (intermediate layer) |
| 50 | Multilayer reflective film |
| 51 | Periodic layered structure portion |
| 110 | Protective film |
| 120 | Absorber film |
| 140 | Resist film |

**Claims**

1. A reflective mask blank comprising:

   a substrate; and
   a multilayer reflective film provided on the substrate and configured to reflect exposure light, the multilayer reflective film including a periodic layered structure portion including a low refractive index layer and a high refractive index layer, wherein
   the low refractive index layer contains ruthenium (Ru), and further contains one or both of carbon (C) and silicon (Si).

2. The reflective mask blank according to claim 1, wherein
   the periodic layered structure portion includes an intermediate layer between at least one of the low refractive index layer and the high refractive index layer, the intermediate layer containing at least one selected from carbon (C), nitrogen (N), and oxygen (O).

3. The reflective mask blank according to claim 1 or 2,

wherein the periodic layered structure portion includes an intermediate layer between at least one of the low refractive index layer and the high refractive index layer, the intermediate layer containing at least one selected from molybdenum (Mo), niobium (Nb), and zirconium (Zr).

4. The reflective mask blank according to any one of claims 1 to 3,
wherein a content of carbon (C) of the low refractive index layer is 4 atom% or more and 40 atom% or less.

5. The reflective mask blank according to any one of claims 1 to 4,
wherein a content of silicon (Si) of the low refractive index layer is 4 atom% or more and 40 atom% or less.

6. The reflective mask blank according to any one of claims 1 to 5, wherein
in an X-ray diffraction pattern by CuKα rays using an out-of-plane measurement method for the multilayer reflective film, a half-value width corresponding to a diffraction angle 2θ of a diffraction peak having the highest intensity observed at a diffraction angle 2θ between 41° and 47° is 4.0° or more.

7. The reflective mask blank according to any one of claims 1 to 6,
wherein an absolute value of film stress of the multilayer reflective film is 500 MPa or less.

8. The reflective mask blank according to any one of claims 1 to 7 comprising a protective film containing ruthenium (Ru) provided on the multilayer reflective film.

9. The reflective mask blank according to any one of claims 1 to 8 comprising an absorber film provided on the multilayer reflective film.

10. A reflective mask comprising:

the reflective mask blank according to any one of claims 1 to **9;** and
a patterned absorber film provided on the multilayer reflective film.

11. A method for manufacturing a reflective mask blank,
wherein the multilayer reflective film of the reflective mask blank according to any one of claims 1 to 10 is formed by a sputtering film formation method using a sputtering apparatus capable of mounting a plurality of targets in a chamber.

FIG. 1

FIG.2

FIG.3

50,51

130
120
110
45
30
40
20

45
30
40
20
10
150

FIG.4

50,51

130
120
110
30
40
20

30
40
20
10
150

FIG.5

130
120
110
45
30
20

50,51

45
30
20
10
150

FIG.6

FIG.7

FIG.8

FIG.9

140
130
120
110
50
10
150

FIG.10

FIG.11

FIG.12

FIG.13

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002246299 A